# EUROPEAN PATENT APPLICATION

(11) **EP 1 156 615 A1**
(43) Date of publication of application: **21.11.2001**
(21) Application number: 00981834.5
(22) Date of filing: 19.12.2000
(51) Int. Cl.: H04L 1/00, H04J 13/00

(54) **CDMA RECEIVING DEVICE AND ERROR CORRECTION METHOD**

(30) Priority: 28.12.1999 JP 37526199
(71) Applicant: MATSUSHITA ELECTRIC INDUSTRIAL CO., LTD., Kadoma-shi, Osaka 571-8501 (JP)
(72) Inventor: SHINOI, Kenichiro, Yokosuka-shi, Kanagawa 239-0847 (JP)
(74) Representative: Grünecker, Kinkeldey, Stockmair & Schwanhäusser Anwaltssozietät
(86) International application number: JP0009003
(87) International publication number: WO0148967

(57) **Abstract**

A Viterbi decoder 102-1 decodes a channel signal having a smallest frame length of channel signals multiplexed, and a CRC calculator 103-1 provides CRC determination to said decoding result. A weighting factor calculator 104 outputs a weighting factor having a large value to a path metric in a time zone where the CRC determination result of CRC calculator 103-1 is "OK", and a weighting factor having a small value to the path metric in a time zone where the CRC determination result of CRC calculator 103-1 is "NG." Viterbi decoders 102-1 to 102-n multiply branch metrics by said weighting factor when providing Viterbi decoding to the other channel signals, respectively. This makes it possible to improve an error correcting capability without increasing an amount of calculations.

## Description

### Technical Field

The present invention relates to a CDMA receiving apparatus, which is used in radio communications such as a cellular phone and the like and has an error correcting function, and relates to an error correcting method.

### Background Art

In radio communications typically a cellular phone, an error occurs due to an influence of multipath fading caused by multiple channel propagation. In order to correct this error, in a mobile communication system, an error correction coding processing is performed at a transmitting side and an error correction decoding processing is performed at a receiving side. Then, as one of error correcting systems, which are often used, there is a convolutional code/Viterbi coding.

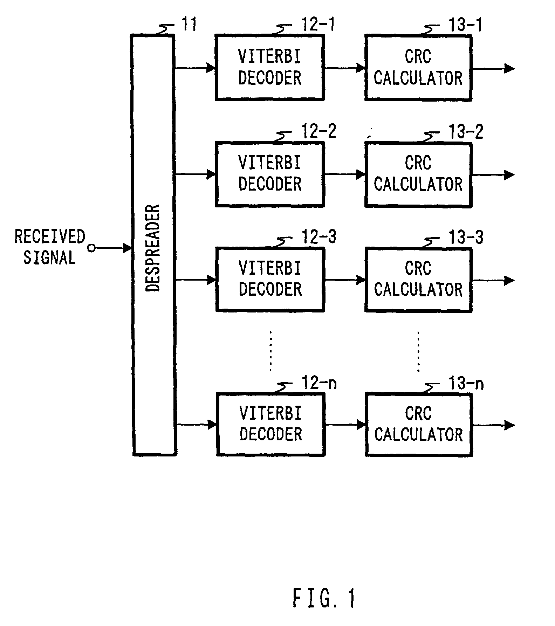

FIG. 1 is a block diagram illustrating the configuration of a conventional CDMA receiving apparatus. A despreader 11 provides despread processing to received signals into which N channels are multiplexed on a channel-by-channel basis to separate the signals every channel. Then, the despreader 11 outputs the respective separated channel signals to Viterbi decoders 12-1 to 12-n in order. The Viterbi decoders 12-1 to 12-n provide Viterbi decoding to the channel signals, respectively, and output the signals subjected to Viterbi decoding to CRC calculators 13-1 to 13-n, respectively. The CRC calculators 13-1 to 13-n carry out CRC calculation, which performs determination as to whether "an error is absent (OK)" or "an error is present (NG)", to the respective output signals of the corresponding Viterbi decoder 12-1 to 12-n.

Thus, the conventional CDMA receiving apparatus separates the multiplexed channel signals, and performs error correction processing such as Viterbi decoding and error detection processing such as CRC calculation every channel signal. Herein, a frame must be retransmitted when an error is detected therein. Resultantly, in order to improve a transmission rate, it is desirable that an error correcting system having a high capability of correcting errors be used.

However, the capability of correcting errors of the error correcting system such as convolutional code/Viterbi coding is fixed, and the conventional CDMA receiving apparatus performs Viterbi decoding every channel signal independently. As a result, the capability of correcting errors cannot be improved to be more than a predetermined value. Moreover, in general, there is a tendency in which an amount of calculations increases as the capability of correcting errors, which the error correction system has, becomes high.

### Disclosure of Invention

It is an object of the present invention is to provide a CDMA receiving apparatus, which is capable of improving the capability of correcting errors without increasing an amount of calculations, and relates to an error correcting method.

The above object can be attained in the following way as in the gist of the present invention set forth below.

More specifically, CRC determination is provided to a decoding result of a channel signal having the shortest frame length. Then, and a path metric of a time zone where a CRC determination result is "OK" in Viterbi decoding of other channel signals multiplexed is multiplied by a weighting factor with a large value, and a path metric of a time zone where a CRC determination result is "NG" is multiplied by a weighting factor with a small value.

### Brief Description of Drawings

FIG. 1 is a block diagram illustrating the configuration of a conventional CDMA receiving apparatus;
FIG. 2 is a block diagram illustrating the configuration of a CDMA receiving apparatus according to Embodiment 1 of the present invention;
FIG. 3 is a view illustrating the specific operations of the CDMA receiving apparatus according to Embodiment 1 of the present invention, particularly the operations of a Viterbi decoder and a weighting factor calculator;
FIG. 4 is a block diagram illustrating the configuration of a CDMA receiving apparatus according to Embodiment 2 of the present invention; and
FIG. 5 is a block diagram illustrating the configuration of a CDMA receiving apparatus according to Embodiment 3 of the present invention.

### Best Mode for Carrying Out the Invention

The inventors of the present invention focused attention on the points in which reliability of a decoding result was high in a time zone where a propagation channel state was good in Viterbi decoding and the propagation channel state could be estimated from a CRC determination result. Then, they found out that an error correction capability could be improved by assigning weights to path metrics of the other channel signals based on the CRC determination result relating to a channel signal having a short frame length of multiplexed channel signals, and reached the present invention.

Embodiments of the present invention will be specifically described with reference to the accompanying drawings.

### (Embodiment 1)

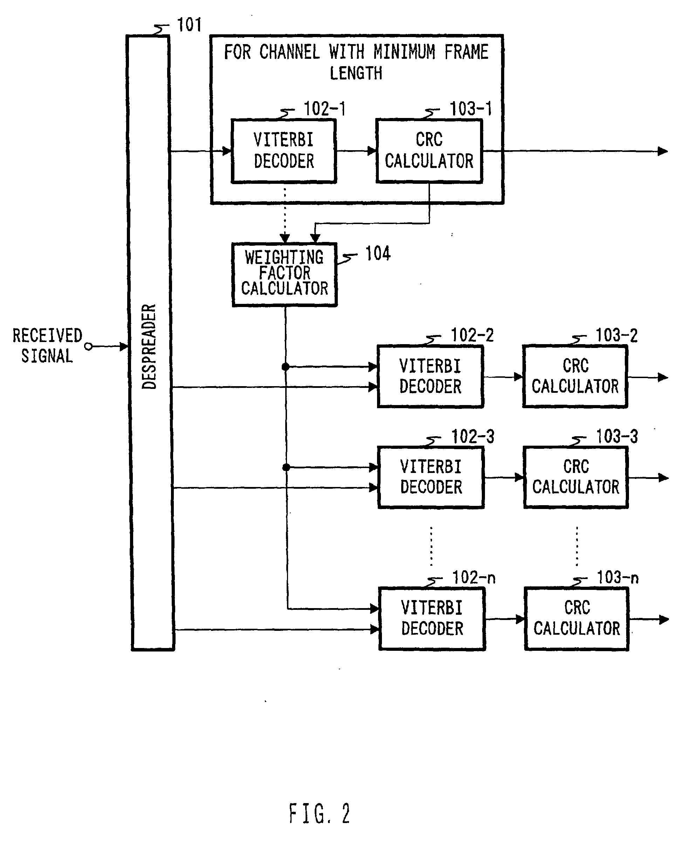

FIG. 2 is a block diagram illustrating the configuration of a CDMA receiving apparatus according to Embodiment 1 of the present invention.

A despreader 101 provides despread processing to received signals into which N channels are multiplexed on a channel-by-channel basis to separate the signals every channel. Then, the despreader 101 outputs a channel signal having the minimum frame length of all separated channel signals to a Viterbi decoder 102-1, and outputs other channel signals to 102-2 to 102-n in order.

The Viterbi decoder 102-1 provides Viterbi decoding to the channel signal having the minimum frame length, and outputs the signal subjected to Viterbi decoding to a CRC calculator 103-1. The Viterbi decoders 102-2 to 102-n provide Viterbi decoding to the inputted channel signals, respectively, using a value obtained by multiplying a path metric by a weighting factor outputted from a weighting factor calculator 104 to be described later. Then, the Viterbi decoders 102-2 to 102-n output the signals subjected to Viterbi decoding to CRC calculators 103-2 to 103-n, respectively.

The CRC calculators 103-1 to 103-n provide CRC calculation to the outputs of the corresponding Viterbi decoders 102-1 to 102-n, respectively, to determine the presence or absence of an error.

The CRC calculator 103-1 outputs the determination result to the weighting factor calculator 104.

The weighting factor calculator 104 sets a weighting factor with a large value to a time zone where the determination result of the CRC calculator 103-1 is "OK", and sets a weighting factor with a small value to a time zone where the determination result is "NG."

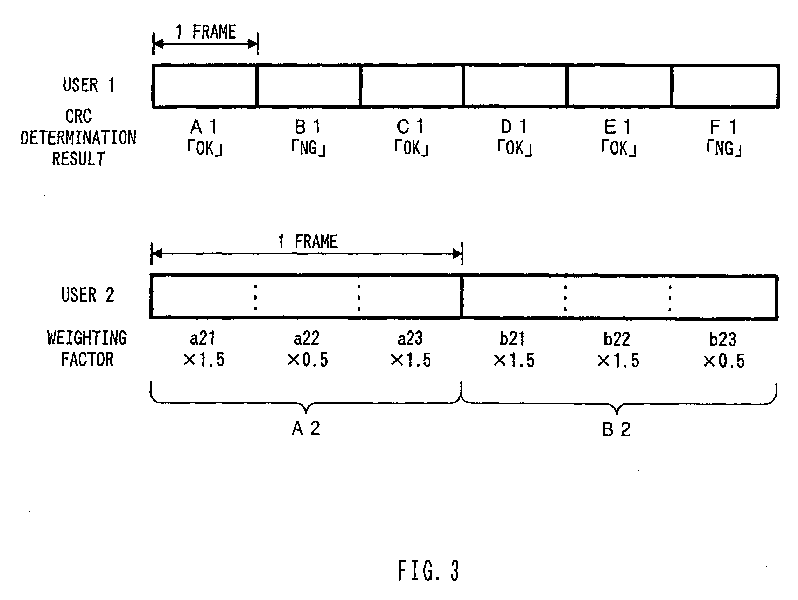

An explanation will be given of the specific operation of the CDMA receiving apparatus of FIG. 2, particularly the operations of the Viterbi decoders 102-2 to 102-n and the weighting factor calculator 104 with reference to FIG. 3.

In FIG. 3, it is assumed that the CDMA receiving apparatus currently provides Viterbi decoding to the channel signal of user 1 using the Viterbi decoder 102-1. Also, it is assumed that the CDMA receiving apparatus currently provides Viterbi decoding to the channel signal of user 2 using the Viterbi decoder 102-2 and that the frame length of the channel signal of user 2 is 1.3 times as large as that of user 1.

Moreover, supposing that the determination results of frames A1, C1, D1, E1 are "OK" and that the determination results of frames B1, F1 are "NG" at the CRC calculator 103-1.

The weighting factor calculator 104 sets a weighting factor with a large value (e.g., "1.5") to the frame portion in a time zone where the determination result of the CRC calculator 103-1 is "OK." On the other hand, the weighting factor calculator 104 sets a weighting factor with a small value (e.g., "0.5") to the frame portion in a time zone where the determination result is "NG."

The Viterbi decoder 102-2 multiplies the path metrics by the weighting factor outputted from the weighting factor calculator 104 to perform Viterbi decoding.

Namely, the Viterbi decoder 102-2 multiplies the path metrics of the portions a21, a 23 of frame A2 in the same time zone as those of frames A1 and C2 by "1.5." Moreover, the Viterbi decoder 102-2 multiplies the path metric of the portions a22 of frame A2 in the same time zone as that of frame B1 by "0.5." Also, the Viterbi decoder 102-2 multiplies the path metric of the portions b23 of frame B2 in the same time zone as that of frame F1 by "0.5."

Thus, the large weight can be assigned to the portions in the time zone where the propagation channel state of the path metrics are good in Viterbi decoding of the other channel signals based on the CRC determination result relating to the channel signal having a short frame length of multiplexed channel signals. This makes it possible to improve an error correction capability without increasing an amount of calculations.

Additionally, the propagation channel state becomes good and reliability of the decoding result becomes high with a decrease in the value of the state metric. For this reason, when the determination result of CRC calculation circuit is "OK", the weighting factor calculator 104 inputs a state metric from the Viterbi decoder 102-1 to make it possible to set a large weighting factor with a decrease in the value of the state metric.

In this case, the weighting factor by which the path metric is multiplied can be more precisely set, so that the error correction capability can be further improved.

### (Embodiment 2)

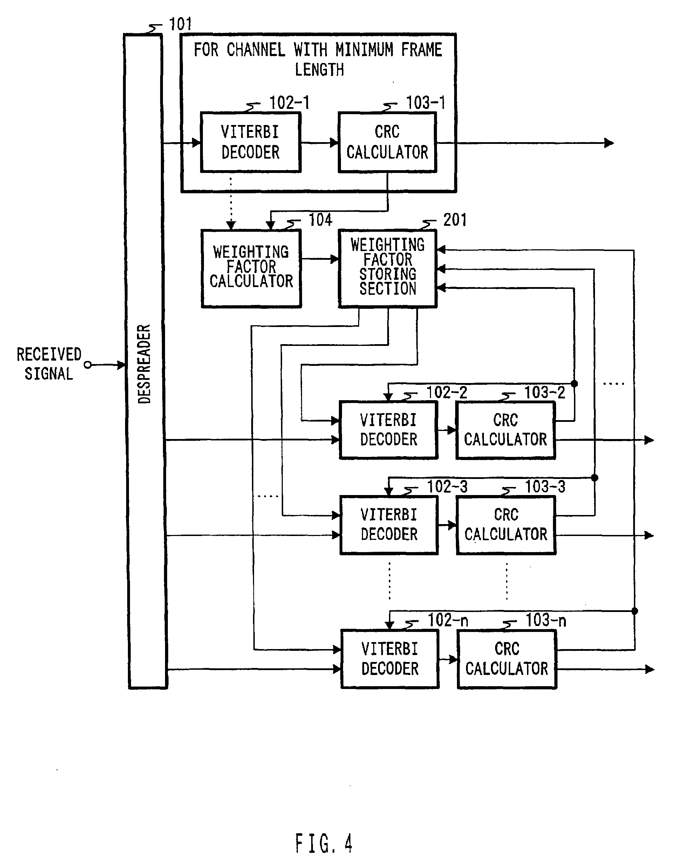

FIG. 4 is a block diagram illustrating the configuration of a CDMA receiving apparatus according to Embodiment 2 of the present invention. In the CDMA receiving apparatus illustrated in FIG.4, regarding the configuration parts common to the CDMA receiving apparatus of FIG. 2 in the operation, the same reference numerals as those of FIG.2 are added thereto, and the explanation is omitted.

The CDMA receiving apparatus of FIG.4 adopts the configuration in which a weight factor storing section 201 is added as compared with the CDMA receiving apparatus of FIG. 2.

The weighting factor calculator 104 outputs the calculated weighting factor to the weight factor storing section 201.

The Viterbi decoders 102-2 to 102-n first perform Viterbi decoding to the inputted channel signals without considering the weighting factor, and output the decoding results to the CRC calculators 103-1 to 103-n, respectively. After that, when the determination results of the corresponding CRC calculators 103-2 to 103-n are "NG", the Viterbi decoders 102-2 to 102-n respectively perform Viterbi decoding to the inputted channels again using a value obtained by multiplying the path metric by the weighting factor outputted from the weighting factor storing section 201.

The CRC calculators 103-2 to 103-n respectively provide the CRC calculation to the output signals of the corresponding Viterbi decoders 102-2 to 102-n to determine a frame error. Then, when the determination result is "NG", each of the CRC calculators 103-2 to 103-n outputs a signal, which indicates that the determination result is "NG", to the corresponding Viterbi decoders 102-2 to 102-n and the weighting factor storing section 201.

When the weighting factor storing section 201 stores the weighting factor inputted from the weighting factor calculator 104 and inputs the signal, which indicates that the determination result is "NG", from each of the CRC calculators 103-2 to 103-n, the weighting factor storing section 201 outputs the weighting factor to the corresponding Viterbi decoders 102-2 to 102-n, respectively.

Thus, only when the result of the CRC determination is "NG", Viterbi decoding is performed with consideration given to the weighting factor. This makes it possible to reduce the amount of calculations as maintaining the error correction capability.

### (Embodiment 3)

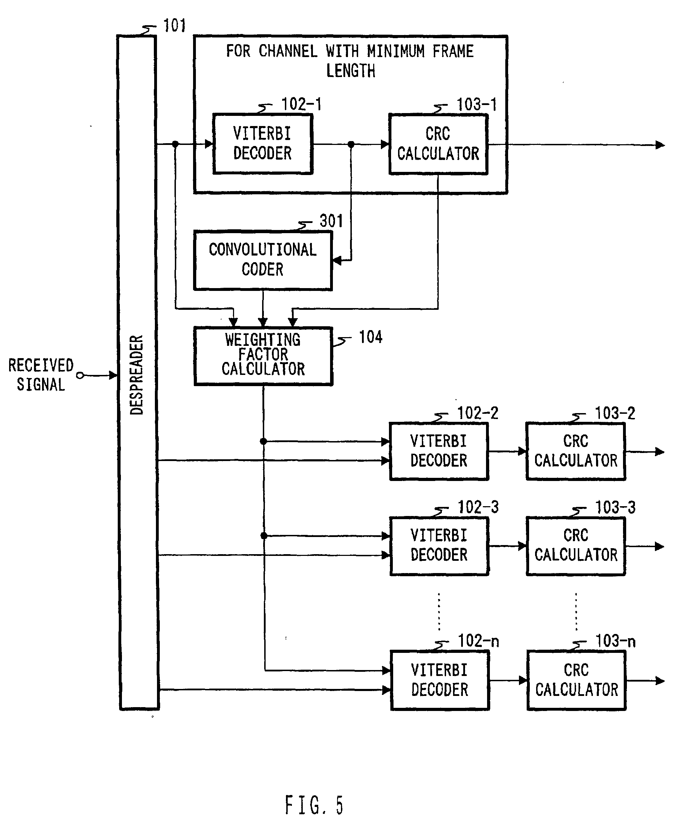

FIG. 5 is a block diagram illustrating the configuration of a CDMA receiving apparatus according to Embodiment 3 of the present invention.

In the CDMA receiving apparatus illustrated in FIG.5, regarding the configuration parts common to the CDMA receiving apparatus of FIG. 2 in the operation, the same reference numerals as those of FIG.2 are added thereto, and the explanation is omitted.

The CDMA receiving apparatus of FIG.5 adopts the configuration in which a convolutional coder 301 is added as compared with the CDMA receiving apparatus of FIG. 2.

The Viterbi decoder 102-1 outputs a signal subjected to Viterbi decoding to the CRC calculator 103-1 and the convolutional coder 301.

The convolutional coder 301 performs convolutional code processing to the signal inputted from the Viterbi decoder 102-1, and outputs the signal subjected to convolutional coding to the weighting factor calculator 104.

When the determination result of the CRC calculator 103-1 is "OK", the weighting factor calculator 104 compares a channel signal, which is outputted from the despreader 101 and which has the minimum frame length, with an output signal of the convolutional coder 301 on a symbol-by-symbol basis in connection with the metric. The weighting factor calculator 104 sets a larger weighting factor as the difference therebetween in the metric decreases.

In this way, the signal subjected to the Viterbi decoding is subjected to convolutional code again. Then, the resultant signal is compared with the signal, which has not been decoded yet. This makes it possible to set the weighting factor on the symbol-by-symbol basis and to further improve the error correction capability.

Additionally, Embodiment 3 can be combined with Embodiment 2.

Moreover, the CDMA receiving apparatus explained in each embodiment is mounted on a base station apparatus and a communication terminal apparatus in a radio communication system.

As is obvious from the above explanation, according to the CDMA receiving apparatus and the error correcting method of the present invention, the large weight can be assigned to the portions in the time zone where the propagation channel state of the path metrics are good in Viterbi decoding of the other channel signals based on the CRC determination results relating to the channel signal having a short frame length of multiplexed channel signals. This makes it possible to improve the error correction capability without increasing the amount of calculations.

This application is based on the Japanese Patent Application No. HEI 11-375261filed on December 28, 1999, entire content of which is expressly incorporated by reference herein

### Industrial Applicability

The present invention is suitable for use in a base station apparatus and a communication terminal apparatus in a radio communication system such as a cellular phone and the like.

## Claims

1. A CDMA receiving apparatus comprising:
despreading means for providing despread processing to a plurality of received signals multiplexed to separate said signals;
first Viterbi decoding means for providing Viterbi decoding to a first signal having a minimum frame length of said despread signals;
first error checking means for providing an error checking to said first signal subjected to Viterbi decoding;
weighting factor calculating means for setting a weighting factor based on whether or not an error is detected; and
one or a plurality of second Viterbi decoding means for providing Viterbi decoding to a second signal other than said first signal using a value obtained by multiplying a path metric by said weighting factor.

2. The CDMA receiving apparatus according to claim 1, wherein said weighting factor calculating means sets a weighting factor having a large value to a time zone where no error is detected, and a weighting factor having a small value to a time zone where an error is detected.

3. The CDMA receiving apparatus according to claim 1, wherein when no error was detected by said first error checking means, said weighting factor calculating means sets a weighting factor having a large value as a value of a state metric calculated by said first Viterbi decoding means decreases.

4. The CDMA receiving apparatus according to claim 1, further comprising one or a plurality of second error checking means for providing an error checking to said second signal subjected to Viterbi decoding, wherein said second error checking means provides Viterbi decoding to said second signal without considering the weighting factor, and provides Viterbi decoding to said second signal again using the value obtained by multiplying the path metric by said weighting factor only when an error is detected by said second error checking means.

5. The CDMA receiving apparatus according to claim 1, further comprising convolutional coding means for providing convolutional code processing to said first signal subjected to Viterbi decoding by said first Viterbi decoding means, wherein when no error is detected by said first error checking means, said weighting factor calculating means compares said first signal prior to Viterbi decoding with an output signal of said convolutional coding means on a symbol-by-symbol basis in connection with said metric and sets a large weighting factor as a difference therebetween in the metric decreases.

6. A base station apparatus having a CDMA receiving apparatus, said CDMA receiving apparatus comprising:
despreading means for providing despread processing to a plurality of received signals multiplexed to separate said signals;
first Viterbi decoding means for providing Viterbi decoding to a first signal having a minimum frame length of said despread signals;
first error checking means for providing an error checking to said first signal subjected to Viterbi decoding;
weighting factor calculating means for setting a weighting factor based on whether or not an error is detected; and
one or a plurality of second Viterbi decoding means for providing Viterbi decoding to a second signal other than said first signal using a value obtained by multiplying a path metric by said weighting factor.

7. A communication terminal apparatus having a CDMA receiving apparatus, said CDMA receiving apparatus comprising:
despreading means for providing despread processing to a plurality of received signals multiplexed to separate said signals;
first viterbi decoding means for providing Viterbi decoding to a first signal having a minimum frame length of said despread signals;
first error checking means for providing an error checking to said first signal subjected to Viterbi decoding;
weighting factor calculating means for setting a weighting factor based on whether or not an error is detected; and
one or a plurality of second Viterbi decoding means for providing Viterbi decoding to a second signal other than said first signal using a value obtained by multiplying a path metric by said weighting factor.

8. An error correcting method comprising the steps of:
providing despread processing to a plurality of received signals multiplexed to separate said signals;
providing Viterbi decoding to a first signal having a minimum frame length of said despread signals;
setting a weighting factor having a large value to a time zone where no error is detected and a weighting factor having a small value to a time zone where an error is detected; and
providing Viterbi decoding to a second signal other than said first signal using a value obtained by multiplying a path metric by said weighting factor.
